# EUROPEAN PATENT SPECIFICATION

(11) **EP 4 439 095 B1**
(45) Date of publication and mention of the grant of the patent: **09.07.2025**
(21) Application number: 23218574.4
(22) Date of filing: 20.12.2023
(51) Int. Cl.: G01R 31/00, G01R 31/28, G01R 31/52, G01R 31/54, G01R 31/58, G01R 31/08

(54) **FAULT DIAGNOSIS METHOD FOR VEHICLE-MOUNTED SENSOR, DEVICE, MEDIUM, AND VEHICLE**
FEHLERDIAGNOSEVERFAHREN FÜR FAHRZEUGMONTIERTEN SENSOR, VORRICHTUNG, MEDIUM UND FAHRZEUG
PROCÉDÉ DE DIAGNOSTIC DE DÉFAILLANCE POUR CAPTEUR MONTÉ SUR VÉHICULE, DISPOSITIF, SUPPORT ET VÉHICULE

(30) Priority: 31.03.2023 CN 202310348079
(43) Date of publication of application: 02.10.2024
(73) Proprietor: Nio Technology (Anhui) Co., Ltd, Hefei City, Anhui 230611 (CN)
(72) Inventor: LAI, Ziyang, Hefei City, Anhui (CN)
(74) Representative: Vossius & Partner Patentanwälte Rechtsanwälte mbB

(56) References cited:
- US-A1- 2015 346 259
- US-B2- 10 222 410
- US-B2- 8 228 068

## Description

The present application claims priority of CN patent application 202310348079.6 filed on March 31, 2023 with the title "Fault diagnosis method for vehicle-mounted sensor, device, medium, and vehicle".

### Technical Field

The disclosure relates to the field of fault diagnosis technologies, and specifically provides a fault diagnosis method for a vehicle-mounted sensor, a system, a vehicle, and a medium.

### Background Art

Today's new energy vehicles become increasingly powerful, so functions of domain controllers become increasingly complex, and external vehicle-mounted sensors, such as cameras, lidars and other systems become increasingly numerous and complex. These sensors, such as vehicle-mounted cameras, are sensors that serve as the domain controllers. The sensors are large in number, and are installed on the exterior of vehicles, making them more exposed to the environment and prone to faults. Therefore, engineers are needed to perform fault diagnosis. Prior art document US10222410 discloses a diagnostic arrangement for sensors in a vehicle, capable of identifying, by supply voltage measurements, various kinds of wiring faults.

Current fault diagnosis methods usually disassemble a sensor for fault detection and determination. However, such methods are not efficient, and disassembling the sensor has a negative impact on the sensor itself and an installation location thereof, and also causes a problem that a fault phenomenon disappears and cannot be detected.

Therefore, there is a need for a novel fault diagnosis solution for a vehicle-mounted sensor to solve the above problems in the art.

### Summary

In order to overcome the above defects, the disclosure is proposed to solve or at least partially solve the problems of fault phenomenon disappearance due to disassembly in fault diagnosis of vehicle-mounted sensors and low fault diagnosis efficiency.

In a first aspect, the disclosure provides a fault diagnosis method for a vehicle-mounted sensor. The vehicle-mounted sensor is connected to a domain controller through a power supply line. The fault diagnosis method for a vehicle-mounted sensor includes: obtaining, by the domain controller, a voltage value and a current value of the vehicle-mounted sensor to obtain power supply status information, where the power supply status information includes an undervoltage flag, an overcurrent flag, and an ADC current sampled value; preliminarily determining, based on assignment of the undervoltage flag, the overcurrent flag, and the ADC current sampled value, a condition of the power supply line of the vehicle-mounted sensor, where the condition of the power supply line includes one of occurrence of a short circuit in the power supply line, occurrence of an impedance fault in the power supply line, occurrence of an open circuit in the power supply line, and normal operation of the power supply line; and determining, based on the condition of the power supply line of the vehicle-mounted sensor, a component that needs to be detected further.

In a technical solution of the above fault diagnosis method for a vehicle-mounted sensor, the domain controller includes a microcontroller, a power circuit, and a high-side switch communicatively connected to the microcontroller and the power circuit, the high-side switch includes a voltage detection register, a current detection register, and an ADC current sampling register, and the step of "obtaining, by the domain controller, a voltage value and a current value of the vehicle-mounted sensor to obtain power supply status information" specifically includes: controlling, by the high-side switch, the power circuit to supply power to the vehicle-mounted sensor, and storing the voltage value and the current value in the voltage detection register and the current detection register as well as the ADC current sampling register, respectively, to obtain the power supply status information; and reading, by the microcontroller, the power supply status information for analysis and determination.

In a technical solution of the above fault diagnosis method for a vehicle-mounted sensor, the step of "reading, by the microcontroller, the power supply status information for analysis and determination" specifically includes: reading, by the microcontroller, a flag state of the voltage detection register, where if the voltage detection register is flagged, the undervoltage flag = 1, otherwise the undervoltage flag = 0; reading, by the microcontroller, a flag state of the current detection register, where if the current detection register is flagged, the overcurrent flag = 1, otherwise the overcurrent flag = 0; and reading, by the microcontroller, an output current value of the ADC current sampling register, where if there is no output current, the ADC current sampled value = 0, otherwise the ADC current sampled value ≠ 0.

In a technical solution of the above fault diagnosis method for a vehicle-mounted sensor, the step of "preliminarily determining, based on assignment of the undervoltage flag, the overcurrent flag, and the ADC current sampled value, a condition of the power supply line of the vehicle-mounted sensor" specifically includes: when the undervoltage flag = 1 and the overcurrent flag = 1, preliminarily determining, by the microcontroller, that a short circuit occurs in the power supply line; when the undervoltage flag = 1 and the overcurrent flag = 0, preliminarily determining, by the microcontroller, that an impedance fault occurs in the power supply line; when the undervoltage flag = 0 and the ADC current sampled value = 0, preliminarily determining, by the microcontroller, that an open circuit occurs in the power supply line; and when the undervoltage flag = 0 and the ADC current sampled value ≠ 0, preliminarily determining, by the microcontroller, that the power supply line operates normally.

In a technical solution of the above fault diagnosis method for a vehicle-mounted sensor, the domain controller further includes a PCB board and a deserializer, the deserializer is electrically connected to the vehicle-mounted sensor to parse data of the vehicle-mounted sensor, and the step of "determining, based on the condition of the power supply line of the vehicle-mounted sensor, a component that needs to be detected further." specifically includes: when it is determined that a short circuit occurs in the power supply line, determining that a cable harness of the power supply line, the vehicle-mounted sensor, the high-side switch, and the PCB board need to be detected further; when it is determined that an impedance fault occurs in the power supply line, determining that an SMD inductor and resistor of the power circuit need to be detected further; when it is determined that an open circuit occurs in the power supply line, determining that a cable harness of the power supply line and the vehicle-mounted sensor need to be detected further; and when it is determined that the power supply line operates normally, determining that the deserializer needs to be detected further.

In a technical solution of the above fault diagnosis method for a vehicle-mounted sensor, the domain controller is communicatively connected to a vehicle display screen or a mobile terminal, and the fault diagnosis method for a vehicle-mounted sensor further includes: transmitting, by the microcontroller, a preliminary determination result and a further detection method to the display screen or the mobile terminal, to guide follow-up processing personnel in processing.

In a technical solution of the above fault diagnosis method for a vehicle-mounted sensor, the vehicle-mounted sensor is a vehicle-mounted camera, and the vehicle-mounted camera is exposed to an external environment for driving assistance.

In a second aspect, an electronic device is provided. The electronic device includes a processor and a storage apparatus adapted to store a plurality of pieces of program code, where the program code is adapted to be loaded and run by the processor to perform the fault diagnosis method for a vehicle-mounted sensor in any one of the technical solutions of the above fault diagnosis method for a vehicle-mounted sensor.

In a third aspect, a computer-readable storage medium is provided. The computer-readable storage medium stores a plurality of pieces of program code, where the program code is adapted to be loaded and run by a processor to perform the fault diagnosis method for a vehicle-mounted sensor in any one of the technical solutions of the above fault diagnosis method for a vehicle-mounted sensor.

In a fourth aspect, a vehicle is provided. The vehicle includes the above electronic device.

The above one or more technical solutions of the disclosure have at least one or more of the following beneficial effects:

In the technical solutions for implementing the disclosure, the domain controller of a vehicle supplies power to the vehicle-mounted sensor such as a vehicle-mounted camera through the power supply line, and obtains a power supply status of the vehicle-mounted sensor. Analysis is made on the power supply status, to obtain a preliminary diagnosis result of the power supply line of the vehicle-mounted sensor, and to provide the further detection method, which is used by after-sales or research personnel to carry out efficient targeted inspections, thereby finally determining a fault cause.

In the disclosure, the microcontroller preliminarily determines the condition of the power supply line of the vehicle-mounted sensor by reading the states of the various registers in the high-side switch, and then determines the fault condition of the relevant components. Specifically, the microcontroller obtains the flag state of the voltage detection register, the flag state of the current detection register, and the current sampled value of the ADC current sampling register in the high-side switch, preliminarily determines one of the four conditions of the power supply line based on the 0, 1 assignments to the undervoltage flag and the overcurrent flag, and the current sampled value, and then determines the component that needs to be detected in a next step. In this way, the vehicle-mounted sensor does not need to be disassembled, and the fault determination may be implemented efficiently and accurately.

### Brief Description of the Drawings

The disclosed content of the disclosure will become more readily understood with reference to the accompanying drawings. Those skilled in the art readily understand that these accompanying drawings are merely for illustrative purposes and are not intended to limit the scope of protection of the disclosure. In addition, similar components are represented by similar numbers in the figures, in which:
FIG. 1 is a schematic flowchart of main steps of a fault diagnosis method for a vehicle-mounted sensor according to an embodiment of the disclosure;
FIG. 2 is another schematic flowchart of main steps of a fault diagnosis method for a vehicle-mounted sensor according to an embodiment of the disclosure; and
FIG. 3 is a schematic diagram of a circuit structure of a fault diagnosis system for a vehicle-mounted sensor according to an embodiment of the disclosure.

### Detailed Description of Embodiments

Some implementations of the disclosure are described below with reference to the accompanying drawings. Those skilled in the art should understand that these implementations are only used to explain the technical principles of the disclosure, and are not intended to limit the scope of protection of the disclosure.

In the description of the disclosure, a "module" or "processor" may include hardware, software, or a combination thereof. A module may include a hardware circuit, various suitable sensors, a communication port, and a memory, or may include a software part, for example, program code, or may be a combination of software and hardware. The processor may be a central processing unit, a microcontroller, a graphics processing unit, a digital signal processor, or any other suitable processor. The processor has a data and/or signal processing function. The processor may be implemented in software, hardware, or a combination thereof. A non-transitory computer-readable storage medium includes any suitable medium that may store program codes, for example, a magnetic disk, a hard disk, an optical disc, a flash memory, a read-only memory, or a random access memory. The term "A and/or B" indicates all possible combinations of A and B, for example, only A, only B, or A and B. The term "at least one of A or B" or "at least one of A and B" has a meaning similar to "A and/or B" and may include only A, only B, or A and B. The terms "a/an" and "this" in the singular form may also include the plural form.

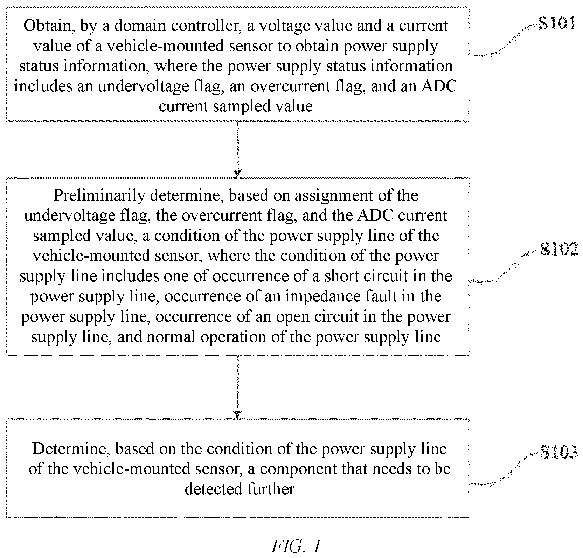

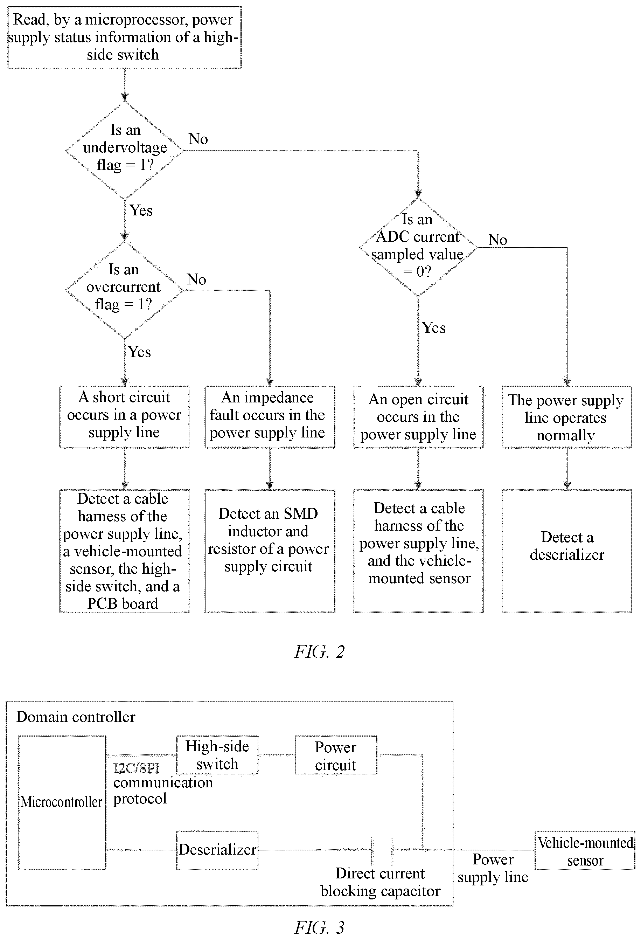

Referring to FIGS. 1 to 3, FIG. 1 is a schematic flowchart of main steps of a fault diagnosis method for a vehicle-mounted sensor according to an embodiment of the disclosure. FIG. 2 is another schematic flowchart of main steps of a fault diagnosis method for a vehicle-mounted sensor according to an embodiment of the disclosure. FIG. 3 is a schematic diagram of a circuit structure of a fault diagnosis system for a vehicle-mounted sensor according to an embodiment of the disclosure. As shown in FIGS. 1 to 3, the fault diagnosis method for a vehicle-mounted sensor in the embodiment of the disclosure mainly includes steps S101 to S103 below.

Step S101: Obtain, by a domain controller, a voltage value and a current value of a vehicle-mounted sensor to obtain power supply status information, where the power supply status information includes an undervoltage flag, an overcurrent flag, and an ADC current sampled value.

In this embodiment, the vehicle-mounted sensor is electrically connected to the domain controller through the power supply line. The domain controller can supply power to the vehicle-mounted sensor and obtain a voltage and a current of the vehicle-mounted sensor to obtain the power supply status information.

Step S102: Preliminarily determine, based on assignment of the undervoltage flag, the overcurrent flag, and the ADC current sampled value, a condition of the power supply line of the vehicle-mounted sensor, where the condition of the power supply line includes one of occurrence of a short circuit in the power supply line, occurrence of an impedance fault in the power supply line, occurrence of an open circuit in the power supply line, and normal operation of the power supply line.

In this embodiment, the undervoltage flag is detected first, and whether the overcurrent flag or the ADC current sampled value is detected next is determined based on the undervoltage flag.

Step S103: Determine, based on the condition of the power supply line of the vehicle-mounted sensor, a component that needs to be detected further.

In this embodiment, after obtaining the assignment of the undervoltage flag and the overcurrent flag, or of the undervoltage flag and the ADC current sampled value, the component that needs to be detected in a next step is determined.

In an implementation, the domain controller includes a microcontroller, a power circuit, and a high-side switch communicatively connected to the microcontroller and the power circuit, the high-side switch includes a voltage detection register, a current detection register, and an ADC current sampling register, and the step of "obtaining, by the domain controller, a voltage value and a current value of the vehicle-mounted sensor to obtain power supply status information" specifically includes: controlling, by the high-side switch, the power circuit to supply power to the vehicle-mounted sensor, and storing the voltage value and the current value in the voltage detection register and the current detection register as well as the ADC current sampling register, respectively, to obtain the power supply status information; and reading, by the microcontroller, the power supply status information for analysis and determination.

Specifically, the microcontroller is communicatively connected to the high-side switch through a communication method, such as an I2C/SPI communication protocol. The high-side switch supplies power to the vehicle-mounted sensors and records the current and the voltage output by itself in corresponding registers. The microcontroller analyzes the information for determination after reading it. The assignment of the undervoltage flag can be obtained from the voltage detection register, the assignment of the overcurrent flag can be obtained from the current detection register, and the ADC current sampled value can be obtained from the ADC current sampling register. The high-side switch also sends the undervoltage flag, the overcurrent flag, and the ADC current sampled value to the microcontroller.

In an implementation, the step of "reading, by the microcontroller, the power supply status information for analysis and determination" specifically includes: reading, by the microcontroller, a flag state of the voltage detection register, where if the voltage detection register is flagged, the undervoltage flag = 1, otherwise the undervoltage flag = 0; reading, by the microcontroller, a flag state of the current detection register, where if the current detection register is flagged, the overcurrent flag = 1, otherwise the overcurrent flag = 0; and reading, by the microcontroller, an output current value of the ADC current sampling register, where if there is no output current, the ADC current sampled value = 0, otherwise the ADC current sampled value ≠ 0.

Specifically, the high-side switch determines a voltage value that needs to be output to a vehicle sensor and controls the power circuit to deliver this voltage value. A voltage detection sensor records the delivered voltage value in real time. When the real-time recorded voltage value is less than the predetermined voltage value that needs to be output to the vehicle sensor by more than 10%, the high-side switch is determined to output an undervoltage, the voltage detection register of the high-side switch is flagged, and the undervoltage flag = 1, otherwise the undervoltage flag = 0. Similarly, the high-side switch determines a current value that needs to be output to the vehicle sensor and controls the power circuit to deliver this current value. A current detection sensor records the delivered current value in real time. When the real-time recorded current value is greater than the predetermined current value that needs to be output to the vehicle sensor by more than 10%, the high-side switch is determined to output an overcurrent, the current detection register of the high-side switch is flagged, and the overcurrent flag = 1, otherwise the overcurrent flag = 0. The ADC current sampling register also records the delivered current value in real time. When there is no output current, the ADC current sampled value = 0, otherwise the ADC current sampled value ≠ 0.

As shown in FIGS. 2 to 3, in an implementation, the step of "preliminarily determining, based on assignment of the undervoltage flag, the overcurrent flag, and the ADC current sampled value, a condition of the power supply line of the vehicle-mounted sensor" specifically includes: when the undervoltage flag = 1 and the overcurrent flag = 1, preliminarily determining, by the microcontroller, that a short circuit occurs in the power supply line; when the undervoltage flag = 1 and the overcurrent flag = 0, preliminarily determining, by the microcontroller, that an impedance fault occurs in the power supply line; when the undervoltage flag = 0 and the ADC current sampled value = 0, preliminarily determining, by the microcontroller, that an open circuit occurs in the power supply line; and when the undervoltage flag = 0 and the ADC current sampled value ≠ 0, preliminarily determining, by the microcontroller, that the power supply line operates normally.

Specifically, the microcontroller first reads the voltage detection register, and determines whether to continue to read the current detection register or the ADC current sampling register based on the assignment of the undervoltage flag in the voltage detection register. Specifically, when the undervoltage flag = 1 is obtained, the current detection register is read, or when the undervoltage flag = 0 is obtained, the ADC current sampling register is read.

As shown in FIGS. 2 to 3, in an implementation, the domain controller further includes a PCB board and a deserializer, the deserializer is electrically connected to the vehicle-mounted sensor to parse data of the vehicle-mounted sensor, and the step of "determining, based on the condition of the power supply line of the vehicle-mounted sensor, a component that needs to be detected further" specifically includes: when it is determined that a short circuit occurs in the power supply line, determining that a cable harness of the power supply line, the vehicle-mounted sensor, the high-side switch, and the PCB board need to be detected further; when it is determined that an impedance fault occurs in the power supply line, determining that an SMD inductor and resistor of the power circuit need to be detected further; when it is determined that an open circuit occurs in the power supply line, determining that a cable harness of the power supply line and the vehicle-mounted sensor need to be detected further; and when it is determined that the power supply line operates normally, determining that the deserializer needs to be detected further.

Specifically, in a preferred embodiment, the deserializer is connected to the vehicle-mounted sensor through the power supply line, and a direct current blocking capacitor is also provided therebetween. The power supply line has one of four possible on-off conditions: normal, short-circuit, short-circuit, and impedance fault. Once it is determined which one the condition is, a specific on-off condition of the power supply line can be used to guide after-sales or research personnel on which components to detect next to obtain a clear fault condition.

In an implementation, the domain controller is communicatively connected to a vehicle display screen or a mobile terminal, and the fault diagnosis method for a vehicle-mounted sensor further includes: transmitting, by the microcontroller, a preliminary determination result and a further detection method to the display screen or the mobile terminal, to guide follow-up processing personnel in processing.

Specifically, the follow-up processing personnel refer in particular to the after-sales or research personnel mentioned above. The vehicle display screen may be, for example, a main display located in the center of an inner front part of the vehicle. The mobile terminal may be a mobile communication device such as a mobile phone or a tablet computer of the follow-up processing personnel. After establishing a communication connection with the above component, the domain controller may transmit a preliminary determination result and a further detection result to the display screen or the mobile terminal, to facilitate viewing of the follow-up processing personnel.

In addition, an alarm may also be provided, and the domain controller is communicatively connected to the alarm to alert the follow-up processing personnel to perform processing.

In an implementation, the vehicle-mounted sensor is a vehicle-mounted camera, and the vehicle-mounted camera is exposed to an external environment for driving assistance.

Specifically, the vehicle-mounted camera is a sensor of the domain controller, which is installed on the exterior of a vehicle to be exposed to the environment for driving assistance functions, and which is a key component of vehicle driving assistance. The vehicle may have a plurality of cameras installed thereon, such as more than 10 vehicle-mounted cameras.

According to the above steps S101 to S103 and subordinate steps thereof, the domain controller of a vehicle supplies power to the vehicle-mounted sensor such as a vehicle-mounted camera through the power supply line, and obtains a power supply status of the vehicle-mounted sensor. Analysis is made on the power supply status, to obtain a preliminary diagnosis result of the power supply line of the vehicle-mounted sensor, and to provide the further detection method to be used by the after-sales or research personnel to carry out efficient targeted inspections, thereby finally determining a fault cause.

In the disclosure, the microcontroller preliminarily determines the condition of the power supply line of the vehicle-mounted sensor by reading the states of the various registers in the high-side switch, and then determines the fault condition of the relevant components. Specifically, the microcontroller obtains the flag state of the voltage detection register, the flag state of the current detection register, and the current sampled value of the ADC current sampling register in the high-side switch, preliminarily determines one of the four conditions of the power supply line based on the 0, 1 assignments to the undervoltage flag and the overcurrent flag, and the current sampled value, and then determines the component that needs to be detected in a next step. In this way, the vehicle-mounted sensor does not need to be disassembled, and the fault determination may be implemented efficiently and accurately.

It should be noted that, although the steps are described in a specific order in the above embodiments, those skilled in the art may understand that in order to implement the effects of the disclosure, different steps are not necessarily performed in such an order, but may be performed simultaneously (in parallel) or in other orders, and these changes shall all fall within the scope of protection of the disclosure.

Those skilled in the art can understand that all or some of the procedures in the method of the above embodiment of the disclosure may also be implemented by a computer program instructing relevant hardware. The computer program may be stored in a computer-readable storage medium, and when the computer program is executed by a processor, the steps of the above method embodiments may be implemented. The computer program includes computer program code, which may be in a source code form, an object code form, an executable file form, some intermediate forms, or the like. The computer-readable storage medium may include: any entity or apparatus that can carry the computer program code, a medium, a USB flash drive, a removable hard disk, a magnetic disk, an optical disc, a computer memory, a read-only memory, a random access memory, an electric carrier signal, a telecommunications signal, and a software distribution medium.

Further, the disclosure further provides an electronic device. In an embodiment of the electronic device according to the disclosure, the electronic device includes a processor and a storage apparatus. The storage apparatus may be configured to store a program for performing the fault diagnosis method for a vehicle-mounted sensor in the above method embodiments, and the processor may be configured to execute a program in the storage apparatus. The program includes but is not limited to the program for performing the fault diagnosis method for a vehicle-mounted sensor in the above method embodiments. For ease of description, only parts related to the embodiments of the disclosure are shown. For specific technical details that are not disclosed, reference may be made to the method part of the embodiments of the disclosure.

Further, the disclosure further provides a computer-readable storage medium. In an embodiment of the computer-readable storage medium according to the disclosure, the computer-readable storage medium may be configured to store a program for performing the fault diagnosis method for a vehicle-mounted sensor in the above method embodiments. The program may be loaded and run by a processor to implement the above fault diagnosis method for a vehicle-mounted sensor. For ease of description, only parts related to the embodiments of the disclosure are shown. For specific technical details that are not disclosed, reference may be made to the method part of the embodiments of the disclosure. The computer-readable storage medium may be a storage apparatus formed by various electronic devices. Optionally, the computer-readable storage medium in the embodiment of the disclosure is a non-transitory computer-readable storage medium.

Further, it should be understood that, because the configuration of modules is merely intended to illustrate function units of the apparatus in the disclosure, physical devices corresponding to these modules may be a processor itself, or part of software, part of hardware, or part of a combination of software and hardware in the processor. Therefore, the number of modules in the figure is merely illustrative.

Those skilled in the art can understand that the modules in the apparatus may be adaptively split or merged. Such a split or combination of specific modules does not cause the technical solutions to depart from the principle of the disclosure. Therefore, technical solutions after any such split or combination shall all fall within the scope of protection of the disclosure.

Heretofore, the technical solutions of the disclosure have been described with reference to the preferred implementations shown in the accompanying drawings. However, those skilled in the art can readily understand that the scope of protection of the disclosure is apparently not limited to these specific implementations. The invention is defined by the claims.

## Claims

1. A fault diagnosis method for a vehicle-mounted sensor, the vehicle-mounted sensor being connected to a domain controller through a power supply line, wherein the fault diagnosis method for a vehicle-mounted sensor comprises:
obtaining (S101), by the domain controller, a voltage value and a current value of the vehicle-mounted sensor to obtain power supply status information, wherein the power supply status information comprises an undervoltage flag, an overcurrent flag, and an ADC current sampled value;
preliminarily determining (S102), based on assignment of the undervoltage flag, the overcurrent flag, and the ADC current sampled value, a condition of the power supply line of the vehicle-mounted sensor, wherein the condition of the power supply line comprises one of occurrence of a short circuit in the power supply line, occurrence of an impedance fault in the power supply line, occurrence of an open circuit in the power supply line, and normal operation of the power supply line; and
determining (S103), based on the condition of the power supply line of the vehicle-mounted sensor, a component that needs to be detected further.

2. The fault diagnosis method for a vehicle-mounted sensor according to claim 1, wherein the domain controller comprises a microcontroller, a power circuit, and a high-side switch communicatively connected to the microcontroller and the power circuit, the high-side switch comprises a voltage detection register, a current detection register, and an ADC current sampling register, and the step of "obtaining, by the domain controller, a voltage value and a current value of the vehicle-mounted sensor to obtain power supply status information" specifically comprises:
controlling, by the high-side switch, the power circuit to supply power to the vehicle-mounted sensor, and storing the voltage value and the current value in the voltage detection register and the current detection register as well as the ADC current sampling register, respectively, to obtain the power supply status information; and
reading, by the microcontroller, the power supply status information for analysis and determination.

3. The fault diagnosis method for a vehicle-mounted sensor according to claim 2, wherein the step of "reading, by the microcontroller, the power supply status information for analysis and determination" specifically comprises:
reading, by the microcontroller, a flag state of the voltage detection register, wherein if the voltage detection register is flagged, the undervoltage flag = 1, otherwise the undervoltage flag = 0;
reading, by the microcontroller, a flag state of the current detection register, wherein if the current detection register is flagged, the overcurrent flag = 1, otherwise the overcurrent flag = 0; and
reading, by the microcontroller, an output current value of the ADC current sampling register, wherein if there is no output current, the ADC current sampled value = 0, otherwise the ADC current sampled value ≠ 0.

4. The fault diagnosis method for a vehicle-mounted sensor according to claim 3, wherein the step of "preliminarily determining, based on assignment of the undervoltage flag, the overcurrent flag, and the ADC current sampled value, a condition of the power supply line of the vehicle-mounted sensor" specifically comprises:
when the undervoltage flag = 1 and the overcurrent flag = 1, preliminarily determining, by the microcontroller, that a short circuit occurs in the power supply line;
when the undervoltage flag = 1 and the overcurrent flag = 0, preliminarily determining, by the microcontroller, that an impedance fault occurs in the power supply line;
when the undervoltage flag = 0 and the ADC current sampled value = 0, preliminarily determining, by the microcontroller, that an open circuit occurs in the power supply line; and
when the undervoltage flag = 0 and the ADC current sampled value ≠ 0, preliminarily determining, by the microcontroller, that the power supply line operates normally.

5. The fault diagnosis method for a vehicle-mounted sensor according to claim 3 or 4, wherein the domain controller further comprises a PCB board and a deserializer, the deserializer is electrically connected to the vehicle-mounted sensor to parse data of the vehicle-mounted sensor, and the step of "determining, based on the condition of the power supply line of the vehicle-mounted sensor, a component that needs to be detected further" specifically comprises:
when it is determined that a short circuit occurs in the power supply line, determining that a cable harness of the power supply line, the vehicle-mounted sensor, the high-side switch, and the PCB board need to be detected further;
when it is determined that an impedance fault occurs in the power supply line, determining that an SMD inductor and resistor of the power circuit need to be detected further;
when it is determined that an open circuit occurs in the power supply line, determining that a cable harness of the power supply line and the vehicle-mounted sensor need to be detected further; and
when it is determined that the power supply line operates normally, determining that the deserializer needs to be detected further.

6. The fault diagnosis method for a vehicle-mounted sensor according to claim 5, wherein the domain controller is communicatively connected to a vehicle display screen or a mobile terminal, and the fault diagnosis method for a vehicle-mounted sensor further comprises:
transmitting, by the microcontroller, a preliminary determination result and a further detection method to the display screen or the mobile terminal, to guide follow-up processing personnel in processing.

7. The fault diagnosis method for a vehicle-mounted sensor according to any one of claims 1 to 6, wherein the vehicle-mounted sensor is a vehicle-mounted camera, and the vehicle-mounted camera is exposed to an external environment for driving assistance.

8. An electronic device, comprising a processor and a storage apparatus adapted to store a plurality of pieces of program code, wherein the program code is adapted to be loaded and run by the processor to perform a fault diagnosis method for a vehicle-mounted sensor according to any one of claims 1 to 7.

9. A computer-readable storage medium storing a plurality of pieces of program code, wherein the program code is adapted to be loaded and run by a processor to perform a fault diagnosis method for a vehicle-mounted sensor according to any one of claims 1 to 7.

10. A vehicle, comprising an electronic device according to claim 8.

## Patentansprüche

1. Fehlerdiagnoseverfahren für einen fahrzeugmontierten Sensor, wobei der fahrzeugmontierte Sensor über eine Leistungsversorgungsleitung mit einer Domänensteuerung verbunden ist, wobei das Fehlerdiagnoseverfahren für einen fahrzeugmontierten Sensor Folgendes umfasst:
Erhalten (S101), durch die Domänensteuerung, eines Spannungswerts und eines Stromwerts des fahrzeugmontierten Sensors zum Erhalten von Leistungsversorgungsstatusinformationen, wobei die Leistungsversorgungsstatusinformationen ein Unterspannungskennzeichen, ein Überspannungskennzeichen und einen abgetasteten ADC-Stromwert umfassen;
vorläufiges Bestimmen (S102), basierend auf einer Zuordnung des Unterspannungskennzeichens, des Überspannungskennzeichens und des abgetasteten ADC-Stromwerts, eines Zustands der Leistungsversorgungsleitung des fahrzeugmontierten Sensors, wobei der Zustand der Leistungsversorgungsleitung eines aus einem Auftreten eines Kurzschlusses in der Leistungsversorgungsleitung, einem Auftreten eines Impedanzfehlers in der Leistungsversorgungsleitung, einem Auftreten einer Stromkreisunterbrechung in der Leistungsversorgungsleitung, und einem normalen Betrieb der Leistungsversorgungsleitung umfasst; und
Bestimmen (S103), basierend auf dem Zustand der Leistungsversorgungsleitung des fahrzeugmontierten Sensors, einer Komponente, die weiter detektiert werden muss.

2. Fehlerdiagnoseverfahren für einen fahrzeugmontierten Sensor nach Anspruch 1, wobei die Domänensteuerung einen Mikrocontroller, eine Leistungsschaltung, und einen High-Side-Schalter, der kommunikativ mit dem Mikrocontroller und der Leistungsschaltung verbunden ist, umfasst, wobei der High-Side-Schalter ein Spannungsdetektionsregister, ein Stromdetektionsregister und ein ADC-Stromabtastregister umfasst, und wobei der Schritt des "Erhaltens, durch die Domänensteuerung, eines Spannungswerts und eines Stromwerts des fahrzeugmontierten Sensors zum Erhalten von Leistungsversorgungsstatusinformationen" speziell Folgendes umfasst:
Steuern, durch den High-Side-Schalter, der Leistungsschaltung zum Zuführen von Leistung zum fahrzeugmontierten Sensor, und Speichern des Spannungswerts und des Stromwerts im Spannungsdetektionsregister bzw. dem Stromdetektionsregister sowie dem ADC-Stromabtastregister, um die Leistungsversorgungsstatusinformationen zu erhalten; und
Lesen, durch den Mikrocontroller, der Leistungsversorgungsstatusinformationen zur Analyse und Bestimmung.

3. Fehlerdiagnoseverfahren für einen fahrzeugmontierten Sensor nach Anspruch 2, wobei der Schritt des "Lesens, durch den Mikrocontroller, der Leistungsversorgungsstatusinformationen zur Analyse und Bestimmung" speziell Folgendes umfasst:
Lesen, durch den Mikrocontroller, eines Kennzeichenzustands des Spannungsdetektionsregisters, wobei, wenn das Spannungsdetektionsregister gekennzeichnet ist, das Unterspannungskennzeichen = 1 ist, andernfalls ist das Unterspannungskennzeichen = 0;
Lesen, durch den Mikrocontroller, eines Kennzeichenzustands des Stromdetektionsregisters, wobei, wenn das Stromdetektionsregister gekennzeichnet ist, das Überspannungskennzeichen = 1 ist, andernfalls ist das Überspannungskennzeichen = 0; und
Lesen, durch den Mikrocontroller, eines Ausgangsstromwerts des ADC-Stromabtastregisters, wobei, wenn es keinen Ausgangsstrom gibt, der abgetastete ADC-Stromwert = 0 ist, andernfalls ist der abgetastete ADC-Stromwert ≠ 0.

4. Fehlerdiagnoseverfahren für einen fahrzeugmontierten Sensor nach Anspruch 3, wobei der Schritt des "vorläufigen Bestimmens, basierend auf einer Zuordnung des Unterspannungskennzeichens, des Überspannungskennzeichens und des abgetasteten ADC-Stromwerts, eines Zustands der Leistungsversorgungsleitung des fahrzeugmontierten Sensors" speziell Folgendes umfasst:
wenn das Unterspannungskennzeichen = 1 ist und das Überspannungskennzeichen = 1 ist, vorläufiges Bestimmen, durch den Mikrocontroller, dass ein Kurzschluss in der Leistungsversorgungsleitung auftritt;
wenn das Unterspannungskennzeichen = 1 ist und das Überspannungskennzeichen = 0 ist, vorläufiges Bestimmen, durch den Mikrocontroller, dass ein Impedanzfehler in der Leistungsversorgungsleitung auftritt;
wenn das Unterspannungskennzeichen = 0 ist und der abgetastete ADC-Stromwert = 0 ist, vorläufiges Bestimmen, durch den Mikrocontroller, dass eine Stromkreisunterbrechung in der Leistungsversorgungsleitung auftritt; und
wenn das Unterspannungskennzeichen = 0 ist und der abgetastete ADC-Stromwert ≠ 0 ist, vorläufiges Bestimmen, durch den Mikrocontroller, dass die Leistungsversorgungsleitung normal arbeitet.

5. Fehlerdiagnoseverfahren für einen fahrzeugmontierten Sensor nach Anspruch 3 oder 4, wobei die Domänensteuerung ferner eine Leiterplatte und einen Deserialisierer umfasst, wobei der Deserialisierer elektrisch mit dem fahrzeugmontierten Sensor verbunden ist, um Daten des fahrzeugmontierten Sensors zu parsen und wobei der Schritt, des "Bestimmens, basierend auf dem Zustand der Leistungsversorgungsleitung des fahrzeugmontierten Sensors, einer Komponente, die weiter detektiert werden muss" speziell Folgendes umfasst:
wenn bestimmt wird, dass ein Kurzschluss in der Leistungsversorgungsleitung auftritt, Bestimmen, dass ein Kabelbaum der Leistungsversorgungsleitung, der fahrzeugmontierte Sensor, der High-Side-Schalter und die Leiterplatte weiter detektiert werden müssen;
wenn bestimmt wird, dass ein Impedanzfehler in der Leistungsversorgungsleitung auftritt, Bestimmen, dass eine SMD-Spule und ein Widerstand der Leistungsschaltung weiter detektiert werden müssen;
wenn bestimmt wird, dass eine Stromkreisunterbrechung in der Leistungsversorgungsleitung auftritt, Bestimmen, dass ein Kabelbaum der Leistungsversorgungsleitung und der fahrzeugmontierte Sensor weiter detektiert werden müssen; und
wenn bestimmt wird, dass die Leistungsversorgungsleitung normal arbeitet, Bestimmen, dass der Deserialisierer weiter detektiert werden muss.

6. Fehlerdiagnoseverfahren für einen fahrzeugmontierten Sensor nach Anspruch 5, wobei die Domänensteuerung kommunikativ mit einem Fahrzeuganzeigebildschirm oder einem mobilen Endgerät verbunden ist und wobei das Fehlerdiagnoseverfahren für einen fahrzeugmontierten Sensor ferner Folgendes umfasst:
Senden, durch den Mikrocontroller, eines vorläufigen Bestimmungsergebnisses und eines weiteren Detektionsverfahrens an den Anzeigebildschirm oder das mobile Endgerät, zum Anleiten des Nachverarbeitungspersonals bei der Verarbeitung.

7. Fehlerdiagnoseverfahren für einen fahrzeugmontierten Sensor nach einem Ansprüche 1 bis 6, wobei der fahrzeugmontierte Sensor eine fahrzeugmontierte Kamera ist und wobei die fahrzeugmontierte Kamera zur Fahrunterstützung gegenüber einer äußeren Umgebung exponiert ist.

8. Elektronische Vorrichtung, umfassend einen Prozessor und eine Speicherungseinrichtung, angepasst zum Speichern von mehreren Stücken Programmcode, wobei der Programmcode dazu angepasst ist, durch den Prozessor geladen und ausgeführt zu werden, um ein Fehlerdiagnoseverfahren für einen fahrzeugmontierten Sensor nach einem der Ansprüche 1 bis 7 durchzuführen.

9. Computerlesbares Speicherungsmedium, das mehrere Stücke Programmcode speichert, wobei der Programmcode dazu angepasst ist, durch einen Prozessor geladen und ausgeführt zu werden, um ein Fehlerdiagnoseverfahren für einen fahrzeugmontierten Sensor nach einem der Ansprüche 1 bis 7 durchzuführen.

10. Fahrzeug, umfassend eine elektronische Vorrichtung nach Anspruch 8.

## Revendications

1. Procédé de diagnostic de défaillance pour un capteur monté sur véhicule, le capteur monté sur véhicule étant connecté à un contrôleur de domaine par le biais d'une ligne d'alimentation électrique, le procédé de diagnostic de défaillance pour un capteur monté sur véhicule comprenant :
l'obtention (S101), par le contrôleur de domaine, d'une valeur de tension et d'une valeur de courant du capteur monté sur véhicule pour obtenir des informations d'état d'alimentation électrique, les informations d'état d'alimentation électrique comprenant une balise de sous-tension, une balise de surintensité, et une valeur échantillonnée de courant CAN ;
la détermination préliminaire (S102), sur la base de l'attribution de la balise de sous-tension, de la balise de surintensité, et de la valeur échantillonnée de courant CAN, d'une condition de la ligne d'alimentation électrique du capteur monté sur véhicule, la condition de la ligne d'alimentation électrique comprenant une condition parmi l'occurrence d'un court-circuit dans la ligne d'alimentation électrique, l'occurrence d'une défaillance d'impédance dans la ligne d'alimentation électrique, l'occurrence d'un circuit ouvert dans la ligne d'alimentation électrique, et le fonctionnement normal de la ligne d'alimentation électrique ; et
la détermination (S103), sur la base de l'état de la ligne d'alimentation électrique du capteur monté sur véhicule, d'un composant qui doit être détecté davantage.

2. Procédé de diagnostic de défaillance pour un capteur monté sur véhicule selon la revendication 1, dans lequel le contrôleur de domaine comprend un microcontrôleur, un circuit de puissance, et un commutateur côté haut connecté de manière à communiquer au microcontrôleur et au circuit de puissance, le commutateur côté haut comprend un registre de détection de tension, un registre de détection de courant, et un registre d'échantillonnage de courant CAN, et l'étape d'« obtention, par le contrôleur de domaine, d'une valeur de tension et d'une valeur de courant du capteur monté sur véhicule pour obtenir des informations d'état d'alimentation électrique » comprend :
le contrôle, par le commutateur côté haut, du circuit d'alimentation pour alimenter en électricité le capteur monté sur véhicule, et le stockage de la valeur de tension et de la valeur de courant dans le registre de détection de tension et le registre de détection de courant ainsi que le registre d'échantillonnage de courant CAN, respectivement, pour obtenir les informations d'état d'alimentation électrique ; et
la lecture, par le microcontrôleur, des informations d'état d'alimentation électrique pour analyse et détermination.

3. Procédé de diagnostic de défaillance pour un capteur monté sur véhicule selon la revendication 2, dans lequel l'étape de « lecture, par le microcontrôleur, des informations d'état d'alimentation électrique pour analyse et détermination » comprend :
la lecture, par le microcontrôleur, d'un état de balise du registre de détection de tension, dans lequel si le registre de détection de tension est balisé, la balise de sous-tension = 1, autrement la balise de sous-tension = 0;
la lecture, par le microcontrôleur, d'un état de balise du registre de détection de courant, dans lequel si le registre de détection de courant est balisé, la balise de surintensité = 1, autrement la balise de surintensité = 0 ; et
la lecture, par le microcontrôleur, d'une valeur de courant de sortie du registre d'échantillonnage de courant CAN, dans lequel s'il n'y a pas de courant de sortie, la valeur échantillonnée de courant CAN = 0, autrement la valeur échantillonnée de courant CAN ≠ 0.

4. Procédé de diagnostic de défaillance pour un capteur monté sur véhicule selon la revendication 3, dans lequel l'étape de « détermination préliminaire, sur la base de l'attribution de la balise de sous-tension, de la balise de surintensité, et de la valeur échantillonnée de courant CAN, d'une condition de la ligne d'alimentation électrique du capteur monté sur véhicule » comprend spécifiquement :
lorsque la balise de sous-tension = 1 et que la balise de surintensité = 1, la détermination préliminaire, par le microcontrôleur, qu'un court-circuit se produit dans la ligne d'alimentation électrique ;
lorsque la balise de sous-tension = 1 et que la balise de surintensité = 0, la détermination préliminaire, par le microcontrôleur, qu'une défaillance d'impédance se produit dans la ligne d'alimentation électrique ;
lorsque l'indicateur de sous-tension = 0 et que la valeur échantillonnée de courant CAN = 0, la détermination préliminaire, par le microcontrôleur, qu'un circuit ouvert se produit dans la ligne d'alimentation électrique ; et
lorsque la balise de sous-tension = 0 et que la valeur échantillonnée de courant CAN ≠ 0, la détermination préliminaire, par le microcontrôleur, que la ligne d'alimentation électrique fonctionne normalement.

5. Procédé de diagnostic de défaillance pour un capteur monté sur véhicule selon la revendication 3 ou la revendication 4, dans lequel le contrôleur de domaine comprend en outre une carte PCB et un convertisseur série-parallèle, le convertisseur série-parallèle est électriquement connecté au capteur monté sur véhicule pour analyser des données du capteur monté sur véhicule, et l'étape de « détermination, sur la base de l'état de la ligne d'alimentation électrique du capteur monté sur véhicule, d'un composant qui doit être détecté davantage » comprend :
lorsqu'il est déterminé qu'un court-circuit se produit dans la ligne d'alimentation électrique, la détermination qu'un faisceau de câbles de la ligne d'alimentation électrique, du capteur monté sur véhicule, du commutateur côté haut, et de la carte PCB doivent être détectés davantage ;
lorsqu'il est déterminé qu'une défaillance d'impédance se produit dans la ligne d'alimentation électrique, la détermination qu'une bobine d'induction SMD et une résistance du circuit d'alimentation doivent être détectées davantage ;
lorsqu'il est déterminé qu'un circuit ouvert se produit dans la ligne d'alimentation électrique, la détermination qu'un faisceau de câbles de la ligne d'alimentation électrique et du capteur monté sur véhicule doivent être détectés davantage ; et
lorsqu'il est déterminé que la ligne d'alimentation électrique fonctionne normalement, la détermination que le convertisseur série-parallèle doit être détecté davantage.

6. Procédé de diagnostic de défaillance pour un capteur monté sur véhicule selon la revendication 5, dans lequel le contrôleur de domaine est connecté de manière à communiquer à un écran d'affichage de véhicule ou à un terminal mobile, et le procédé de diagnostic de défaillance pour un capteur monté sur véhicule comprend en outre :
la transmission, par le microcontrôleur, d'un résultat de détermination préliminaire et d'un procédé de détection supplémentaire à l'écran d'affichage ou au terminal mobile, pour guider le personnel de traitement de suivi dans le traitement.

7. Procédé de diagnostic de défaillance pour un capteur monté sur véhicule selon l'une quelconque des revendications 1 à 6, dans lequel le capteur monté sur véhicule est une caméra montée sur véhicule, et la caméra montée sur véhicule est exposée à un environnement externe pour assistance à la conduite.

8. Dispositif électronique, comprenant un processeur et un appareil de stockage conçu pour stocker une pluralité d'éléments de code de programme, le code de programme étant conçu pour être chargé et exécuté par le processeur afin de réaliser un procédé de diagnostic de défaillance pour un capteur monté sur véhicule selon l'une quelconque des revendications 1 à 7.

9. Support de stockage lisible par ordinateur stockant une pluralité d'éléments de code de programme, le code de programme étant conçu pour être chargé et exécuté par un processeur afin de réaliser un procédé de diagnostic de défaillance pour un capteur monté sur véhicule selon l'une quelconque des revendications 1 à 7.

10. Véhicule, comprenant un dispositif électronique selon la revendication 8.
